# FASCICULE DE BREVET EUROPEEN

(11) **EP 3 775 862 B1**
(45) Date de publication et mention de la délivrance du brevet: **06.04.2022**
(21) Numéro de dépôt: 19717544.1
(22) Date de dépôt: 19.03.2019
(51) Int. Cl.: G01N 27/414, B01L 3/00

(54) **MICRO-CAPTEUR POUR DÉTECTER DES ESPÈCES CHIMIQUES ET PROCÉDÉ DE FABRICATION ASSOCIÉ**
MIKROSENSOR ZUR DETEKTION CHEMISCHER SPEZIEN UND ZUGEHÖRIGES HERSTELLUNGSVERFAHREN
MICRO-SENSOR FOR DETECTING CHEMICAL SPECIES AND ASSOCIATED MANUFACTURING METHOD

(30) Priorité: 30.03.2018 FR 1852783
(43) Date de publication de la demande: 17.02.2021
(73) Titulaire: SOITEC, 38190 Bernin (FR)
(72) Inventeur: GHYSELEN, Bruno, 38170 SEYSSINET (FR)
(74) Mandataire: IP Trust
(86) Numéro de dépôt international: PCT/FR2019/050610
(87) Numéro de publication internationale: WO 2019/186027

(56) Documents cités:
- EP-A1- 0 893 827
- US-A1- 2005 212 016
- US-A1- 2011 227 043
- US-A1- 2015 014 752
- US-A1- 2016 187 288
- BANGDAO CHEN ET AL: "Fabrication of a graphene field effect transistor array on microchannels for ethanol sensing", APPLIED SURFACE SCIENCE, vol. 258, no. 6, 31 mai 2011 (2011-05-31), pages 1971-1975, XP028356646, ISSN: 0169-4332, DOI: 10.1016/J.APSUSC.2011.05.101 [extrait le 2011-05-31]

## Description

### DOMAINE DE L'INVENTION

La présente invention concerne le domaine des micro-capteurs pour la détection d'espèces chimiques sous forme ionique présentes dans un fluide. Elle concerne en particulier un micro-capteur comprenant un transistor à effet de champ sensible aux ions et comprenant des canaux micro-fluidiques intégrés pour acheminer le fluide.

### ARRIERE PLAN TECHNOLOGIQUE DE L'INVENTION

Les transistors à effet de champ (FET) initialement dédiés au domaine de l'électronique de circuits ont rapidement été étendus à de nouveaux champs d'application dans le domaine de l'analyse chimique. On connait en particulier les transistors à effet de champ sensibles aux ions (ISFET, pour « Ion Sensitive Field Effect Transistor »). Dans les micro-capteurs basés sur des ISFET, la grille du transistor est placée en contact avec la solution chimique à analyser ; les espèces chimiques présentes dans la solution, modifient le potentiel électrochimique au voisinage de la grille, et peuvent ainsi influencer le courant circulant entre le drain et la source du transistor. Les caractéristiques de conduction du ISFET sont donc susceptibles de changer en fonction de la concentration des ions en contact avec la grille.

En général, dans un micro-capteur basé sur un transistor ISFET, l'approche classique consiste à mettre en contact la solution chimique avec la grille du transistor (ou avec l'oxyde de grille), au niveau de la face avant dudit transistor, c'est-à-dire dans la région active du composant, là où des éléments sensibles du transistor sont formés (électrodes de source, de drain, contacts métalliques,...). Même si des couches d'encapsulation locales sont utilisées pour isoler ces éléments de la solution chimique, des infiltrations peuvent être la cause de défaillance ou d'usure prématurée du transistor. En outre, la formation de telles couches d'encapsulation complique davantage le procédé de réalisation.

Alternativement, le document WO00/51180 propose la formation d'un ISFET sur un substrat SOI (« Silicon on Insulator »), puis la formation d'une couche support isolante sur la face avant du transistor et enfin le retrait partiel ou total du substrat de silicium pour exposer la couche d'oxyde du SOI ; ladite couche d'oxyde est alors placée en contact avec la solution chimique. Cette approche évite la mise en contact de la face avant du transistor avec la solution chimique et prévient donc des risques d'infiltration. Par contre, elle présente l'inconvénient de mettre en œuvre une étape d'élimination par gravure de plusieurs centaines de microns du substrat de silicium. Cette élimination, peut être agressive pour la couche active (couche superficielle en silicium du SOI) et les éléments sensibles du transistor.

Dans le cas d'une gravure partielle du substrat de silicium, uniquement à l'aplomb de la grille, une autre difficulté vient de l'alignement requis entre la face avant et la face arrière du substrat SOI.

Dans le cas d'une gravure totale du substrat de silicium, il est nécessaire de former des canaux pour acheminer et confiner la solution à l'aplomb de la grille, ce qui peut également poser des problèmes d'alignement.

Les documents US2011/227043 et US2016/187288 proposent de former des canaux dans une couche du substrat sous-jacent au composant actif du micro-capteur, après élaboration du composant. Ces canaux sont ouverts par gravure chimique : il subsiste donc un risque d'endommagement du composant actif par exemple, par infiltrations chimiques.

### OBJET DE L'INVENTION

La présente invention vise à pallier tout ou partie des inconvénients précités. L'invention concerne un micro-capteur pour analyse chimique selon la revendication indépendante 1, basé sur un transistor à effet de champ et le procédé de fabrication associé selon la revendication indépendante 9.

### BREVE DESCRIPTION DE L'INVENTION

L'invention concerne un micro-capteur pour la détection d'ions dans un fluide, comprenant :
- un transistor à effet de champ présentant une source, un drain, une région active entre la source et le drain, et une grille disposée au-dessus de la région active,
- une couche active dans laquelle est formée la région active,
- une couche diélectrique disposée sous la couche active,
- un substrat support, disposé sous la couche diélectrique et comportant au moins une cavité enterrée, localisée à l'aplomb de la grille du transistor, pour accueillir le fluide,
le micro-capteur étant caractérisé en ce que la cavité comporte un étranglement au voisinage de la couche diélectrique et une partie évasée dans une zone plus profonde du substrat support.

Selon d'autres caractéristiques avantageuses et non limitatives de l'invention, prises seules ou selon toute combinaison techniquement réalisable :
- la cavité enterrée est reliée à un réseau de canaux enterrés formés dans le substrat support, pour acheminer le fluide ;
- la couche active présente une épaisseur comprise entre quelques nanomètres et quelques centaines de nanomètres ;
- la couche de diélectrique présente une épaisseur comprise entre quelques angströms et quelques dizaines de nanomètres ;
- la couche active est formée d'au moins un matériau semi-conducteur choisi parmi le silicium, le silicium-germanium, le germanium, les composés III-V (arséniures, phosphures, nitrures) ;
- la couche diélectrique est formée d'au moins un matériau isolant choisi parmi le dioxyde de silicium, le nitrure de silicium, un oxynitrure, l'oxyde d'hafnium (HfO2), l'alumine (Al2O3), l'oxyde de tantale (Ta2O5) ou un empilement de couches de ces matériaux ;
- la couche active est en silicium et le transistor est élaboré selon une architecture FDSOI ;
- la cavité présente des dimensions latérales comprises entre environ 100 nanomètres et quelques dizaines de microns et une profondeur comprise entre quelques dizaines de nanomètres et quelques centaines de microns ;
- la cavité comporte un étranglement au voisinage de la couche diélectrique et une partie évasée dans une zone plus profonde du substrat support.

L'invention concerne également un procédé de fabrication d'un micro-capteur pour la détection d'ions dans un fluide, comprenant :
- La fourniture d'une structure comportant une couche active, disposée sur une couche diélectrique, elle-même disposée sur un substrat support ; la structure comportant au moins une cavité enterrée, formée dans le substrat support et disposée sous la couche diélectrique ;
- L'élaboration d'un transistor à effet de champ présentant une source, un drain, une région active formée dans la couche active et s'étendant entre la source et le drain, et une grille disposée au-dessus de la région active, à l'aplomb de la cavité.

Selon d'autres caractéristiques avantageuses et non limitatives de l'invention, prises seules ou selon toute combinaison techniquement réalisable :
- la fourniture de la structure comprend :
   ∘ la formation sur une première face du substrat support d'au moins une cavité, par gravure,
   ∘ l'assemblage de la première face du substrat support sur une première face d'un substrat donneur comportant la couche diélectrique,
   ∘ l'amincissement du substrat donneur, de manière à former la couche active.
- l'amincissement du substrat donneur comprend :
   ∘ préalablement à l'assemblage, l'implantation d'espèces légères dans le substrat donneur, au niveau de sa première face, pour former une couche enterrée fragile ;
   ∘ après l'assemblage, la séparation au niveau de la couche enterrée fragile, pour former d'une part la structure comportant la couche active disposée sur la couche diélectrique, elle-même disposée sur le substrat support, et d'autre part un substrat donneur résiduel.

### BREVE DESCRIPTION DES DESSINS

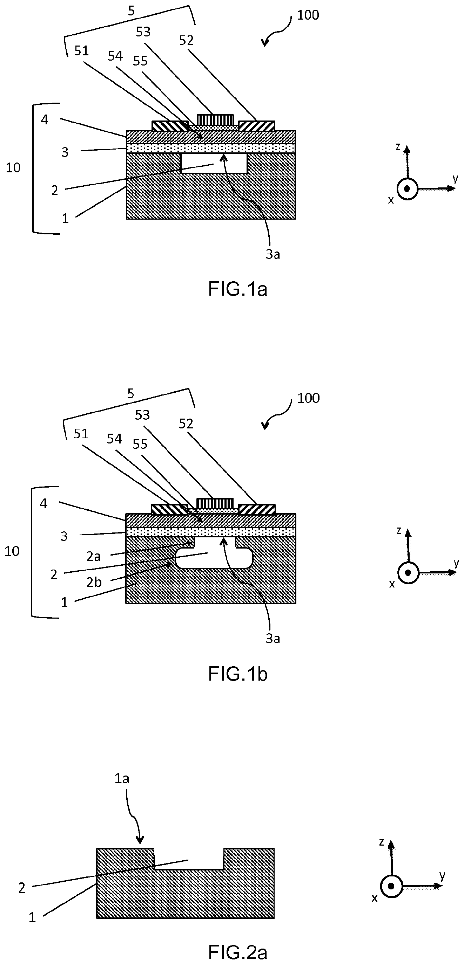

D'autres caractéristiques et avantages de l'invention ressortiront de la description détaillée qui va suivre en référence aux figures annexées sur lesquelles :
- les figures la et 1b présentent des micro-capteurs, celui de la figure 1b étant conforme à l'invention;

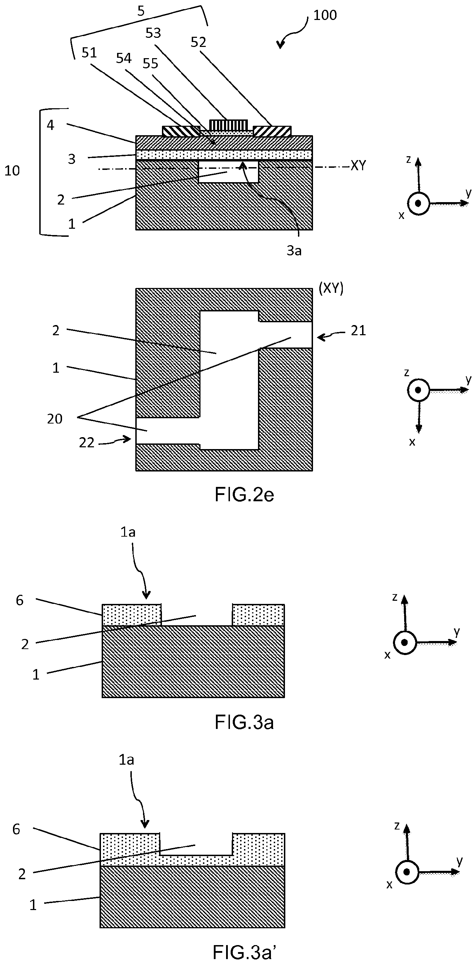

- les figures 2a à 2e et 3a à 3d présentent des étapes du procédé de fabrication d'un micro-capteur conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

L'invention concerne un micro-capteur 100 pour la détection d'ions dans un fluide. Le micro-capteur 100 comprend une structure 10 comportant une couche active 4, disposée sur une couche diélectrique 3, elle-même disposée sur un substrat support 1 (figure 1a). La couche active 4 est destinée à contenir et/ou supporter au moins un composant micro-électronique, en particulier un transistor à effet de champ (FET). Par ailleurs, la couche active 4 peut être à base d'un seul matériau ou peut être constituée de plusieurs couches de différents matériaux.

Avantageusement, la couche active 4 est formée d'au moins un matériau semi-conducteur choisi parmi le silicium, le silicium-germanium, le germanium, les composés III-V (arséniures, phosphures, nitrures, etc). Et elle présente une épaisseur comprise entre quelques nanomètres et quelques centaines de nanomètres.

Le substrat support 1 peut être à base d'un matériau semi-conducteur ou encore isolant, tel que le silicium, le germanium, le carbure de silicium, l'arséniure de gallium, le phosphure d'indium, le saphir ou le verre. Préférentiellement, le substrat support 1 est formé en silicium.

La structure 10 comprend en outre au moins une cavité 2 enterrée, formée dans le substrat support 1 et disposée sous la couche diélectrique 3. Une partie de la surface 3a de la couche diélectrique 3 se trouve donc libre, en vis-à-vis de la cavité 2.

Le micro-capteur 100 comprend également un transistor à effet de champ 5 formé dans et sur la couche active 4 de la structure 10. Il présente une source 51, un drain 52, une région active 54 entre la source 51 et le drain 52 et une grille 53 disposée au-dessus de la région active 54. La région active 54 est formée dans la couche active 4, elle correspond au canal de conduction dans lequel le courant est susceptible de circuler, entre la source 51 et le drain 52, lorsque le transistor 5 est en état passant. La grille 53 est disposée sur une couche isolante 55 (oxyde de grille), qui la sépare de la couche active 4.

Préférentiellement, la couche active 4 est de faible épaisseur ; par exemple elle pourra présenter une épaisseur de 15nm. Dans le cas d'une couche active 4 en silicium, le transistor 5 est avantageusement élaboré selon une technologie classique CMOS dans et sur ladite couche 4 ; il est par exemple de type MOSFET et fonctionne en mode totalement déserté (« fully depleted »). Ledit transistor 5 est avantageusement réalisé selon l'architecture FDSOI (« Fully Depleted SOI »).

Dans le cas d'une couche active 4 en matériau III-V, ledit transistor 5 peut être de type HEMT (« High Electron Mobility Transistor »).

Un transistor FET pour la détection chimique d'ions doit être très sensible. En particulier, la tension de seuil du transistor doit préférentiellement être sensible à la variation du potentiel électrochimique au voisinage de la grille, pour détecter le plus précisément possible une variation de concentration d'ions dans la solution mise en contact avec la grille.

Un transistor FET 5 en mode « fully depeleted » du micro-capteur 100, élaboré sur une couche active 4, en particulier en silicium, et une couche diélectrique 3, présentent des caractéristiques tout à fait adaptées à cette application.

Selon l'invention, la grille 53 est élaborée sensiblement à l'aplomb de la cavité enterrée 2 et tout ou partie de la région active 54 est localisé au-dessus de la cavité 2.

La cavité enterrée 2 est destinée à accueillir le fluide à analyser et à le mettre en contact avec la couche diélectrique 3. La cavité 2 pourra présenter des dimensions latérales (dans le plan (x,y) sur les figures) comprises entre environ 100 nanomètres et quelques dizaines de microns et une profondeur (selon l'axe z sur les figures) comprise entre quelques dizaines de nanomètres et quelques centaines de microns. A titre d'exemple, une cavité 2 pourra présenter une largeur (selon l'axe y sur les figures) d'environ 150nm, une longueur (selon l'axe x sur les figures) d'environ 500nm et une profondeur de l'ordre de 150nm.

Avantageusement, la couche diélectrique 3 est formée d'au moins un matériau isolant parmi le dioxyde de silicium, le nitrure de silicium, un oxynitrure, l'oxyde d'hafnium (HfO2), l'alumine (Al2O3), l'oxyde de tantale (Ta2O5) ou un empilement de couches de ces matériaux. La couche de diélectrique 3 présente une épaisseur comprise entre quelques angströms et quelques dizaines de nanomètres.

Les ions présents dans le fluide, vont modifier le potentiel électrochimique au niveau de la surface 3a de la couche diélectrique 3. Le transistor FET 5 fonctionne alors avec une double grille : la grille supérieure 53 qui peut être polarisée à un certain potentiel et la grille chimique inférieure dont le potentiel (au niveau de la surface 3a de la couche diélectrique 3) est influencé par la présence et la concentration des ions du fluide contenu dans la cavité 2.

Le matériau isolant de la couche diélectrique 3 est choisi en fonction du type d'ions à détecter dans le fluide.

Selon l'invention, comme cela est illustré sur la figure 1b, la cavité 2 comporte un étranglement 2a au voisinage de la couche diélectrique 3 ; au niveau de cet étranglement 2a, la cavité 2 présente des dimensions latérales correspondant sensiblement aux dimensions de la grille 53. La cavité 2 comporte en outre une partie évasée 2b dans sa zone plus profonde. Cette partie évasée 2b favorise la circulation du fluide. Notons également que l'étranglement 2a, de dimensions latérales réduites, favorise la tenue mécanique de l'empilement de couches 3,4 disposé au-dessus de la cavité 2 et peut simplifier la fabrication de la structure 10 et/ou du micro-capteur 100.

A titre d'exemple, une cavité 2 selon ce mode de réalisation pourra présenter, au niveau de l'étranglement 2a, une largeur (selon l'axe y) d'environ 100nm, une longueur (selon l'axe x) d'environ 200nm, et au niveau de la partie évasée 2b, une largeur (selon l'axe y) d'environ 1000nm, une longueur (selon l'axe x) d'environ 2000nm. Elle pourra par ailleurs présenter une profondeur de l'ordre de 500nm.

De manière avantageuse, la (au moins une) cavité enterrée 2 est reliée à un réseau de canaux enterrés 20 formés dans le substrat support 1, pour acheminer continument ou périodiquement le fluide. Le réseau comporte une entrée 21 et une sortie 22 de fluide (figure 2e). Un système externe de pompage permet de faire circuler le fluide dans le réseau de canaux 20, pour l'amener dans la cavité 2. Après la mesure, le fluide est retiré de la cavité 2 par pompage ou chassé de la cavité 2 par l'injection dans le réseau de canaux 20 d'une solution de rinçage.

La présente invention concerne également un procédé de fabrication du micro-capteur 100 pour la détection d'ions dans un fluide.

Le procédé de fabrication comprend une première étape de fourniture d'une structure 10 comportant une couche active 4, disposée sur une couche diélectrique 3, elle-même disposée sur un substrat support 1. La structure 10 comporte au moins une cavité enterrée 2, formée dans le substrat support 1 et disposée sous la couche diélectrique 3.

Selon un mode de réalisation avantageux, cette première étape inclut la formation, sur une première face la du substrat support 1, de la (au moins une) cavité 2, par gravure (figure 2a). Comme réalisé classiquement lors des étapes de lithographie et gravure, une couche de masquage (non représentée) est déposée sur la première face la et retirée localement aux endroits destinés à être gravés pour former la ou les cavités 2. Le réseau de canaux 20 communiquant avec la cavité 2 est préférentiellement élaboré simultanément.

Selon des variantes illustrées sur les figures 3a et 3a', le substrat support 1 comporte une couche intermédiaire 6 au niveau de sa première face la. La (ou les) cavité (s) 2 et le réseau de canaux 20 sont formés dans la couche intermédiaire 6. La couche intermédiaire 6 est préférentiellement formée d'au moins un matériau isolant choisi parmi le dioxyde de silicium, le nitrure de silicium, un oxynitrure, l'oxyde d'hafnium (HfO2), l'alumine (Al2O3), l'oxyde de tantale (Ta2O5) ou un empilement de couches de ces matériaux.

Une cavité 2 pourra présenter des dimensions latérales (dans le plan (x,y) sur les figures) comprises entre environ 100 nanomètres et quelques dizaines de microns, et une profondeur (selon l'axe z sur les figures) comprise entre quelques dizaines de nanomètres et quelques centaines de microns. Les canaux 20 pourront présenter des dimensions dans des gammes similaires.

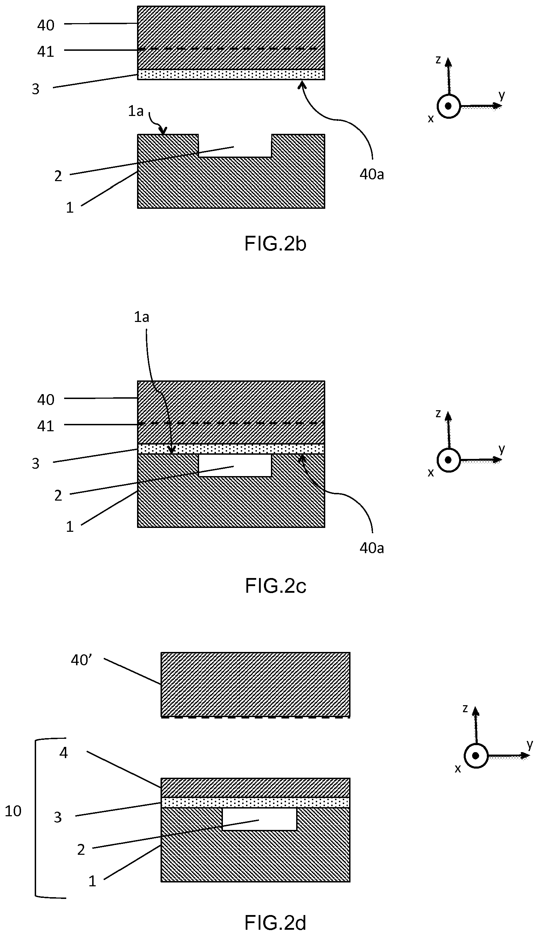

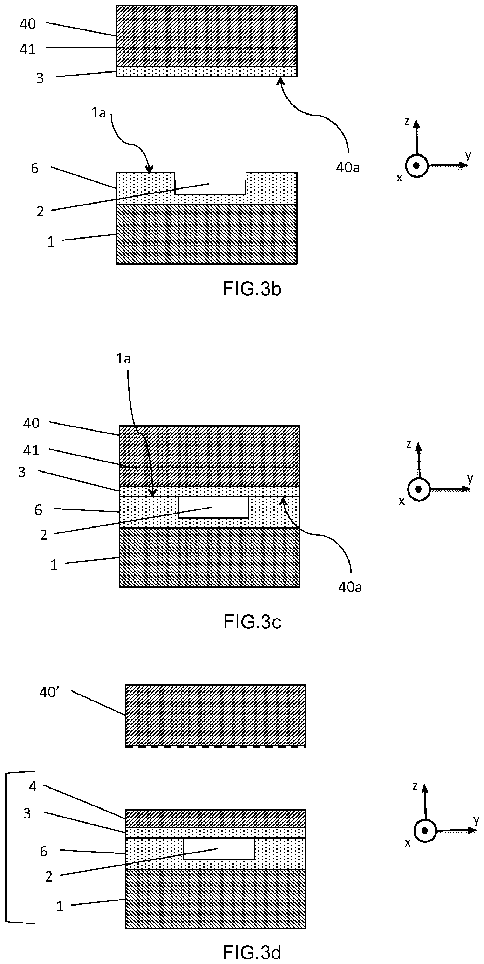

Toujours selon le mode de réalisation avantageux, la première étape du procédé comprend la fourniture d'un substrat donneur 40, présentant une première face 40a et comportant une couche diélectrique 3 (figures 2b, 3b). La couche diélectrique 3 peut être élaborée par croissance thermique ou par dépôt, selon la nature du ou des matériau(x) la composant et selon la nature du substrat donneur 40. La couche diélectrique est préférentiellement formée d'au moins un matériau isolant choisi parmi le dioxyde de silicium, le nitrure de silicium, un oxynitrure, l'oxyde d'hafnium (HfO2), l'alumine (Al2O3), l'oxyde de tantale (Ta2O5) ou un empilement de couches de ces matériaux. Le substrat donneur 40 est préférentiellement formé d'au moins un matériau semi-conducteur choisi parmi le silicium, le silicium-germanium, le germanium, les composés III-V (arséniures, phosphures, nitrures, etc.).

Pour former la couche active 4 à partir du substrat donneur 40, on utilisera préférentiellement un procédé de transfert spécialement adapté aux couches minces à très minces et assurant une bonne uniformité d'épaisseur de couche et une très bonne qualité cristalline et de surface.

Par exemple, le procédé Smart Cut^{®} peut être mis en œuvre. Une implantation d'espèces légères (hydrogène et/ou hélium) est alors effectuée dans le substrat donneur 40, au niveau de sa première face 40a, de manière à former une couche enterrée fragile 41 (figures 2b, 3b).

L'assemblage de la première face la du substrat support 1 comportant la (ou les) cavité(s) 2 et le réseau de canaux 20, sur la première face 40a d'un substrat donneur 40 comportant une couche diélectrique 3 est ensuite opéré (figures 2c, 3c). La cavité 2 et le réseau de canaux 20 se trouvent ainsi enterrés dans la structure assemblée.

Avantageusement, l'assemblage est fait par collage direct, par adhésion moléculaire des deux surfaces mises en contact. Le principe de l'adhésion moléculaire, bien connu dans l'état de l'art ne sera pas décrit plus en détail ici. Notons qu'un très bon état de surface (propreté, faible rugosité, ...) des substrats à assembler est requis, pour obtenir une bonne qualité finale de la structure 10.

Toujours selon le mode de réalisation avantageux, la première étape du procédé comprend l'amincissement du substrat donneur 40, de manière à former la couche active 4.

La séparation au niveau de la couche enterrée fragile 41, peut s'opérer au cours d'un traitement thermique, par exemple entre 250°C et 550°C, et/ou sous sollicitation mécanique. Cette séparation permet d'une part, de former la structure 10 comportant la couche active 4 disposée sur la couche diélectrique 3, elle-même disposée sur le substrat support 1, et d'autre part de former un substrat donneur résiduel 40' (figures 2d, 3d).

Des étapes de finition (par exemple oxydation thermique, lissage thermique, ou autres) sont appliquées à la surface séparée de la couche active 4, de manière à lui conférer la qualité requise (en termes d'épaisseur, uniformité, qualité cristalline, rugosité, défectivité) pour l'élaboration subséquente des transistors FET.

Le procédé de fabrication comprend une deuxième étape d'élaboration d'un transistor 5 à effet de champ présentant une source 51, un drain 52, une région active 54 formée dans la couche active 4 et s'étendant entre la source 51 et le drain 52. Le transistor 5 comporte également une grille 53 disposée au-dessus de la région active 54, à l'aplomb de la (au moins une) cavité 2 (figure 2e). L'alignement entre la cavité 2 et la grille 53 du transistor 5 pourra être aisément réalisé en utilisant les marques d'alignement élaborées lors de la formation de la cavité 2 et des canaux 20 sur le substrat support 1.

Les méthodes classiques d'élaboration de transistors basées sur la technologie CMOS pourront être utilisées.

Avantageusement, chaque cavité 2 présente une dimension, dans le plan (x,y), inférieure à 1000nm voire inférieure à 200nm, l'autre dimension pouvant aller jusqu'à quelques dizaines de microns (figure 2e). La plus petite dimension (largeur) est selon l'axe source 51 - drain 52 (axe y sur les figures). La plus grande dimension (longueur) correspond préférentiellement à la largeur de la région active 54, c'est-à-dire à l'étendue des électrodes de source 51, de drain 52 et de grille 53 (selon l'axe x sur les figures). Une telle configuration de la cavité 2 dans le plan (x,y) est favorable à la tenue mécanique des portions d'empilement de couches active 4 et diélectrique 3 se trouvant suspendues au-dessus de ladite cavité 2.

Selon une variante du procédé de fabrication, la (ou les) cavité (s) 2 et le réseau de canaux 20, réalisés dans le substrat support 1, pourront être remplis par un matériau sacrificiel. L'élaboration de la structure 10 et du transistor 5 du micro-capteur 100 est effectuée alors même que les cavités 2 sont remplies dudit matériau. Finalement, après que le transistor FET 5 soit réalisé, une étape de gravure dans la couche active 4 et la couche diélectrique 3 permet d'accéder aux cavité (s) 2 et canaux 20 ; le matériau sacrificiel est gravé chimiquement pour vider les cavité(s) 2 et canaux 20, une couche d'encapsulation protégeant les éléments sensibles en face avant du transistor 5. Le matériau sacrificiel est choisi de sorte qu'il soit préférentiellement attaqué par la gravure chimique, par rapport au substrat support 1 et à la couche diélectrique 3.

Selon un mode de réalisation particulier, le micro-capteur 100 peut comporter plusieurs transistors 5 à effet de champ, notamment pour augmenter l'efficacité de traitement du signal électrique traduisant la détection d'ions. Ces transistors 5 peuvent partager, par exemple une même grille chimique inférieure (au niveau de la surface 3a de la couche diélectrique 3) disposée sur une même cavité 2 pour améliorer la sensibilité du micro-capteur 100.

Le miro-capteur 100 comporte au moins une cavité 2 et un réseau de canaux 20 intégrés, enterrés sous un transistor FET 5 ; ce dernier est configuré pour fonctionner avec une grille supérieure 53 et une grille chimique inférieure (au niveau de la surface 3a de la couche diélectrique 3) dont le potentiel électrochimique est influencé par la présence et la concentration d'espèces chimiques dans la cavité 2. La présence des cavité(s) 2 et réseau de canaux 20 dans le substrat support 1 de la structure 10 servant à l'élaboration du transistor 5, évite les étapes de gravures profondes de l'état de la technique pour exposer la couche de diélectrique après la formation du transistor. L'assemblage de substrats supplémentaires ou la réalisation de micro-usinages postérieurs à la réalisation du transistor, pour former des réservoirs et canaux d'acheminement du fluide à analyser, ne sont pas non plus nécessaires grâce à la structure 10 avec cavité(s) 2 enterrée(s) supportant le micro-capteur 100 selon l'invention.

Le micro-capteur 100 selon l'invention peut être utilisé pour la détection d'espèces chimiques sous forme ionique dans un fluide gazeux ou liquide. A titre d'exemple, il pourra trouver des applications dans le domaine de détection de gaz ou encore des capteurs biologiques pour la détection d'analytes en solution ou la mesure de pH.

## Revendications

1. Micro-capteur (100) pour la détection d'ions dans un fluide, comprenant :
• un transistor à effet de champ (5) présentant une source (51), un drain (52), une région active (54) entre la source (51) et le drain (52), et une grille (53) disposée au-dessus de la région active (54),
• une couche active (4) dans laquelle est formée la région active (54),
• une couche diélectrique (3) disposée sous la couche active (4),
• un substrat support (1), disposé sous la couche diélectrique (3) et comportant au moins une cavité (2) enterrée, localisée à l'aplomb de la grille (53) du transistor (5), pour accueillir le fluide ;
le micro-capteur (100) étant caractérisé en que la cavité (2) comporte un étranglement (2a) au voisinage de la couche diélectrique (3) et une partie évasée (2b) dans une zone plus profonde du substrat support (1).

2. Micro-capteur (100) selon la revendication précédente, dans lequel la cavité (2) enterrée est reliée à un réseau de canaux (20) enterrés formés dans le substrat support (1), pour acheminer le fluide.

3. Micro-capteur (100) selon l'une des revendications précédentes, dans lequel la couche active (4) présente une épaisseur comprise entre quelques nanomètres et quelques centaines de nanomètres.

4. Micro-capteur selon l'une des revendications précédentes dans lequel la couche de diélectrique (3) présente une épaisseur comprise entre quelques angströms et quelques dizaines de nanomètres.

5. Micro-capteur (100) selon l'une des revendications précédentes dans lequel la couche active (4) est formée d'au moins un matériau semi-conducteur choisi parmi le silicium, le silicium-germanium, le germanium, les composés III-V (arséniures, phosphures, nitrures).

6. Micro-capteur (100) selon l'une des revendications précédentes, dans lequel la couche diélectrique (3) est formée d'au moins un matériau isolant choisi parmi le dioxyde de silicium, le nitrure de silicium, un oxynitrure, l'oxyde d'hafnium (HfO2), l'alumine (Al2O3), l'oxyde de tantale (Ta2O5) ou un empilement de couches de ces matériaux.

7. Micro-capteur (100) selon l'une des revendications précédentes, dans lequel la couche active (4) est en silicium et le transistor (5) est formé selon une architecture FDSOI.

8. Micro-capteur (100) selon l'une des revendications précédentes, dans lequel la cavité (2) présente des dimensions latérales comprises entre environ 100 nanomètres et quelques dizaines de microns et une profondeur comprise entre quelques dizaines de nanomètres et quelques centaines de microns.

9. Procédé de fabrication d'un micro-capteur (100) selon l'une des revendications précédentes, comprenant :
• La fourniture d'une structure (10) comportant la couche active (4), disposée sur la couche diélectrique (3), elle-même disposée sur le substrat support (1) ; la structure (10) comportant la -au moins une- cavité (2) enterrée, formée dans le substrat support (1) et disposée sous la couche diélectrique (3) ;
• Puis, l'élaboration du transistor (5) à effet de champ présentant la source (51), le drain (52), la région active (54) formée dans la couche active (4) et s'étendant entre la source (51) et le drain (52), et la grille (53) disposée au-dessus de la région active (54), à l'aplomb de la cavité (2).

10. Procédé de fabrication selon la revendication précédente, dans lequel la fourniture de la structure (10) comprend :
• la formation sur une première face (la) du substrat support (1) de la au moins une cavité (2), par gravure,
• l'assemblage de la première face (la) du substrat support (1) sur une première face (40a) d'un substrat donneur (40) comportant la couche diélectrique (3),
• l'amincissement du substrat donneur (40), de manière à former la couche active (4).

11. Procédé de fabrication selon la revendication précédente, dans lequel l'amincissement du substrat donneur (40) comprend :
• préalablement à l'assemblage, l'implantation d'espèces légères dans le substrat donneur (40), au niveau de sa première face (40a), pour former une couche enterrée fragile ) ;
• après l'assemblage, la séparation au niveau de la couche enterrée fragile (41), pour former d'une part la structure (10) comportant la couche active (4) disposée sur la couche diélectrique (3), elle-même disposée sur le substrat support (1), et d'autre part un substrat donneur résiduel (40').

## Patentansprüche

1. Mikrosensor (100) zum Erfassen von Ionen in einem Fluid, der Folgendes umfasst:
• einen Feldeffekttransistor (5), der eine Source (51), einen Drain (52), einen aktiven Bereich (54) zwischen der Source (51) und dem Drain (52) und ein Gate (53) vorweist, das über dem aktiven Bereich (54) angeordnet ist,
• eine aktive Schicht (4), in der der aktive Bereich (54) ausgebildet ist,
• eine dielektrische Schicht (3), die unter der aktiven Schicht (4) angeordnet ist,
• ein Trägersubstrat (1), das unter der dielektrischen Schicht (3) angeordnet ist und wenigstens einen beerdigten Hohlraum (2) aufweist, der sich senkrecht zu dem Gate (53) des Transistors (5) zum Aufnehmen des Fluids befindet; wobei der Mikrosensor (100) **dadurch gekennzeichnet ist, dass** der Hohlraum (2) eine Einschnürung (2a) in der Nähe der dielektrischen Schicht (3) und einen erweiterten Teil (2b) in einer tieferen Zone des Trägersubstrats (1) aufweist.

2. Mikrosensor (100) nach dem vorhergehenden Anspruch, wobei der beerdigte Hohlraum (2) mit einem beerdigten Kanalnetz (20) verbunden ist, das in dem Trägersubstrat (1) zum Befördern des Fluids ausgebildet ist.

3. Mikrosensor (100) nach einem der vorhergehenden Ansprüche, wobei die aktive Schicht (4) eine Dicke zwischen einigen Nanometern und einigen hundert Nanometern vorweist.

4. Mikrosensor nach einem der vorhergehenden Ansprüche, wobei die dielektrische Schicht (3) eine Dicke zwischen einigen Angström und einigen zehn Nanometern vorweist.

5. Mikrosensor (100) nach einem der vorhergehenden Ansprüche, wobei die aktive Schicht (4) aus wenigstens einem Halbleitermaterial ausgebildet ist, das aus Silizium, Silizium-Germanium, Germanium, III-V-Verbindungen (Arseniden, Phosphiden, Nitriden) ausgewählt ist.

6. Mikrosensor (100) nach einem der vorhergehenden Ansprüche, wobei die dielektrische Schicht (3) aus wenigstens einem Isoliermaterial ausgebildet ist, das aus Siliziumdioxid, Siliziumnitrid, einem Oxynitrid, Hafniumoxid (HfO2), Aluminiumoxid (Al2O3), Tantaloxid (Ta2O5) oder einem Schichtstapel aus diesen Materialien ausgewählt ist.

7. Mikrosensor (100) nach einem der vorhergehenden Ansprüche, wobei die aktive Schicht (4) aus Silizium besteht und der Transistor (5) gemäß einer FDSOI-Architektur ausgebildet ist.

8. Mikrosensor (100) nach einem der vorhergehenden Ansprüche, wobei der Hohlraum (2) seitliche Abmessungen zwischen etwa 100 Nanometern und einigen zehn Mikrometern und eine Tiefe zwischen einigen zehn Nanometern und einigen hundert Mikrometern vorweist.

9. Herstellungsverfahren für einen Mikrosensor (100) nach einem der vorhergehenden Ansprüche, das Folgendes umfasst:
• Bereitstellen einer Struktur (10), die die aktive Schicht (4) aufweist, die auf der dielektrischen Schicht (3) angeordnet ist, die wiederum auf dem Trägersubstrat (1) angeordnet ist; wobei die Struktur (10) den -wenigstens einen- beerdigten Hohlraum (2) aufweist, der in dem Trägersubstrat (1) ausgebildet und unter der dielektrischen Schicht (3) angeordnet ist;
• anschließend Bearbeiten des Feldeffekttransistors (5), der die Source (51), den Drain (52), den aktiven Bereich (54), der in der aktiven Schicht (4) ausgebildet ist und sich zwischen der Source (51) und dem Drain (52) erstreckt, und das Gate (53) vorweist, das über dem aktiven Bereich (54) senkrecht zu dem Hohlraum (2) angeordnet ist.

10. Herstellungsverfahren nach dem vorhergehenden Anspruch, wobei das Bereitstellen der Struktur (10) Folgendes umfasst:
• Ausbilden des wenigstens einen Hohlraums (2) auf einer ersten Seite (1a) des Trägersubstrats (1) durch Ätzen,
• Zusammenfügen der ersten Seite (1a) des Trägersubstrats (1) mit einer ersten Seite (40a) eines Donorsubstrats (40), das die dielektrische Schicht (3) aufweist,
• Dünnermachen des Donorsubstrats (40), so dass die aktive Schicht (4) ausgebildet wird.

11. Herstellungsverfahren nach dem vorhergehenden Anspruch, wobei das Dünnermachen des Donorsubstrats (40) Folgendes umfasst:
• vor dem Zusammenfügen, Implantieren von leichten Arten in das Donorsubstrat (40) an seiner ersten Seite (40a), zum Ausbilden einer zerbrechlichen beerdigten Schicht;
• nach dem Zusammenfügen, Trennen an der zerbrechlichen beerdigten Schicht (41), zum Ausbilden einerseits der Struktur (10), die die aktive Schicht (4) aufweist, die auf der dielektrischen Schicht (3) angeordnet ist, die wiederum auf dem Trägersubstrat (1) angeordnet ist, und andererseits eines restlichen Donorsubstrats (40').

## Claims

1. Microsensor (100) for detecting ions in a fluid, comprising:
• a field-effect transistor (5) having a source (51), a drain (52), an active region (54) between the source (51) and the drain (52), and a gate (53) which is arranged above the active region (54),
• an active layer (4) in which the active region (54) is formed,
• a dielectric layer (3) which is arranged under the active layer (4),
• a support substrate (1) which is arranged under the dielectric layer (3) and comprises at least one buried cavity (2), which is located vertically in line with the gate (53) of the transistor (5), for accommodating the fluid; the microsensor (100) being **characterized in that** the cavity (2) comprises a narrowing (2a) in the vicinity of the dielectric layer (3) and a flared part (2b) in a deeper zone of the support substrate (1).

2. Microsensor (100) according to the preceding claim, wherein the buried cavity (2) is connected to a network of buried channels (20) which are formed in the support substrate (1) for transporting the fluid.

3. Microsensor (100) according to either of the preceding claims, wherein the active layer (4) has a thickness of between a few nanometers and a few hundred nanometers.

4. Microsensor according to any of the preceding claims, wherein the dielectric layer (3) has a thickness of between a few angstroms and a few tens of nanometers.

5. Microsensor (100) according to any of the preceding claims, wherein the active layer (4) is formed of at least one semiconductor material chosen from silicon, silicongermanium, germanium, III-V compounds (arsenides, phosphides, nitrides).

6. Microsensor (100) according to any of the preceding claims, wherein the dielectric layer (3) is formed of at least one insulating material chosen from silicon dioxide, silicon nitride, an oxynitride, hafnium oxide (HfO2), alumina (Al2O3), tantalum oxide (Ta2O5) or a stack of layers of these materials.

7. Microsensor (100) according to any of the preceding claims, wherein the active layer (4) is made of silicon and the transistor (5) is formed according to an FDSOI architecture.

8. Microsensor (100) according to any of the preceding claims, wherein the cavity (2) has lateral dimensions between approximately 100 nanometers and a few tens of microns and a depth between a few tens of nanometers and a few hundred microns.

9. Method for manufacturing a microsensor (100) according to any of the preceding claims, comprising:
• providing a structure (10) that comprises the active layer (4) which is arranged on the dielectric layer (3), which is itself arranged on the support substrate (1); the structure (10) comprising the-at least one-buried cavity (2) which is formed in the support substrate (1) and arranged under the dielectric layer (3);
• then producing the field-effect transistor (5) which has the source (51), the drain (52), the active region (54) which is formed in the active layer (4) and extends between the source (51) and the drain (52), and the gate (53) which is arranged above the active region (54), vertically in line with the cavity (2).

10. Manufacturing method according to the preceding claim, wherein providing the structure (10) comprises:
• forming the at least one cavity (2) on a first surface (1a) of the support substrate (1) by etching,
• joining the first surface (1a) of the support substrate (1) and a first surface (40a) of a donor substrate (40) which comprises the dielectric layer (3),
• thinning the donor substrate (40), so as to form the active layer (4).

11. Manufacturing method according to the preceding claim, wherein thinning the donor substrate (40) comprises:
• prior to joining, implantation of light species in the donor substrate (40), on the first surface (40a) thereof, to form a fragile buried layer;
• after joining, separation at the fragile buried layer (41) to form, on the one hand, the structure (10) that comprises the active layer (4) which is arranged on the dielectric layer (3), which is itself arranged on the support substrate (1), and, on the other hand, a residual donor substrate (40').
